# EUROPEAN PATENT APPLICATION

(11) **EP 4 757 118 A1**
(43) Date of publication of application: **10.06.2026**
(21) Application number: 25220452.4
(22) Date of filing: 03.12.2025
(51) Int. Cl.: H02J 9/06, G01R 31/08, G01R 31/327, G06Q 50/06, H02J 13/12, H02J 13/14, H02M 1/32

(54) **FAULT DETECTION METHOD, SYSTEM, ELECTRONIC DEVICE AND MEDIUM**

(30) Priority: 05.12.2024 CN 202411778926
(71) Applicant: Vertiv Tech Co., Ltd., Guangdong 518055 (CN)
(72) Inventor: FENG, Langlang, Shenzhen 518055 (CN); ZHANG, Longyun, Shenzhen 518055 (CN); XU, Wei, Shenzhen 518055 (CN)
(74) Representative: Ambroz, Simon

(57) **Abstract**

A fault detection method includes: sequentially transmitting a first control signal to control chips corresponding to each of the plurality of battery switches after detecting a reverse feeding fault, when the plurality of battery switches are turned on and the plurality of utility power switches are turned off, causing a corresponding battery switch to be turned off; and detecting a difference between a front and a back terminal voltage of each of the plurality of utility power switches connected to the corresponding battery switch when the corresponding battery switch is turned off, where each of the plurality of utility power switches is off; determining that the plurality of utility power switches are short-circuited when a difference between the front terminal voltage and the back terminal voltage of at least one of the plurality of utility power switches is greater than or equal to a preset threshold; otherwise, determining that the plurality of utility power switches are normal.

## Description

### CROSS REFERENCE TO RELATED APPLICATION

This application claims priority to Chinese Patent Application No. 202411778926.3 titled "FAULT DETECTION METHOD, SYSTEM, ELECTRONIC DEVICE AND MEDIUM", filed on December 05, 2024 with the China National Intellectual Property Administration (CNIPA).

### FIELD

The present disclosure relates to circuit technology, and more particular to a fault detection method, a system, an electronic device, and a medium.

### BACKGROUND

A UPS is an uninterruptible power supply (Uninterruptible Power Supply) with an energy storage apparatus. The UPS is mainly applied for a device with a relatively high requirement for the stability of the power supply, and is able to supply power through two manners of utility power and battery, so as to provide an uninterrupted power supply. However, uninterruptible power supplies are at risk of a reverse feeding fault. That is, when the utility power switch is short-circuited in a battery mode, the reverse-fed battery voltage will be present at the utility power input side of the uninterruptible power supply, which will bring an electric shock risk to maintenance personnel; and when the utility power is suddenly restored, mutual reverse feeding may occur between the utility power voltage and the battery voltage, thereby further damaging the rectifier and causing load power failure.

In the related art, the detection of reverse feeding fault may be realized by adding a high-precision current sensor at the utility power switch. However, this will increase the complexity of the circuit design and increase the maintenance and production costs.

### SUMMARY

A fault detection method, a system, an electronic device and medium are provided in the present disclosure to reduce the cost of reverse feeding fault detection.

In one aspect of the present disclosure, a fault detection method for an uninterruptible power supply is provided, wherein the uninterruptible power supply comprises: a plurality of utility power switches, a plurality of battery switches, a battery and a plurality of conversion modules; each utility power switch is connected between a utility power and one of the plurality of conversion modules, each battery switch is connected between the battery and an output terminal of one of the plurality of utility power switches, and each conversion module is configured to supply power to a load, wherein the method comprises: in a case that the plurality of battery switches are turned on and the plurality of utility power switches are turned off, after detecting a reverse feeding fault, sequentially transmitting a first control signal to a plurality of control chips each corresponding to one of the plurality of battery switches to cause a respective control chip received the first control signal to control the corresponding battery switch to be turned off; and detecting a difference between a front terminal voltage and a back terminal voltage of each utility power switch connected to the corresponding battery switch when the corresponding battery switch is turned off, wherein each of the plurality of utility power switches is in an off state; if the difference between the front terminal voltage and the back terminal voltage of at least one of the plurality of utility power switches is greater than or equal to a preset threshold, determining that the at least one of the plurality of utility power switches is short-circuited and maintaining the corresponding battery switch to be turned off; otherwise, determining that the plurality of utility power switches are normal, and controlling the corresponding battery switch to be turned on after a predetermined time.

In one possible implementation of the present disclosure, wherein each of the plurality of conversion modules comprises one rectifier of a plurality of rectifiers, an input terminal of each rectifier is connected to an output terminal of each utility power switch, an output terminal of each rectifier is connected to an input terminal of the battery, each rectifier comprises a power device, and the method further comprises: stopping sending a second control signal to a first power device when a battery switch is turned off, wherein the first power device is a power device included in a first rectifier, and the first rectifier is connected to the battery switch receiving the first control signal.

In one possible implementation of the present disclosure, wherein each conversion module further comprises an inverter, an input terminal of the inverter is connected to the output terminal of the rectifier, and an output terminal of the inverter is connected to the load.

In one possible implementation of the present disclosure, the number of the plurality of conversion modules is more than one, and the plurality of conversion modules are connected in parallel.

In one possible implementation of the present disclosure, the method further includes: detecting whether a voltage at an input terminal of the utility power is greater than a reverse feeding threshold, and determining that the reverse feeding fault occurs when the voltage at the input terminal of the utility power is greater than the reverse feeding threshold.

In a possible implementation of the present disclosure, before sequentially transmitting the first control signal to each of the plurality of battery switches, the method further comprises: setting a main path reverse feeding flag for each of the plurality of conversion modules; wherein the method further comprises: after determining that the reverse feeding fault is eliminated, clearing the main path reverse feeding flag.

In another aspect of the present disclosure, a power supply system is provided, which comprises an uninterruptible power supply and a detecting apparatus, wherein the uninterruptible power supply comprises: a plurality of utility power switches, a plurality of battery switches, a battery and a plurality of conversion modules; each utility power switch is connected between a utility power and one of the plurality of conversion modules, each battery switch is connected between the battery and an output terminal of one of the plurality of utility power switches, and each conversion module is configured to supply power to a load; wherein the detecting apparatus comprises: a transmitting module configured to, in a case that the plurality of battery switches are turned on and the plurality of utility power switches are turned off, after detecting a reverse feeding fault, sequentially transmit a first control signal to a plurality of control chips each corresponding to one of the plurality of battery switches to cause a respective control chip received the first control signal to control the corresponding battery switch to be turned off; and a detecting module configured to, detect a difference between a front terminal voltage and a back terminal voltage of each utility power switch connected to the corresponding battery switch when the corresponding battery switch is turned off, wherein each of the plurality of utility power switches is in an off state; if the difference between the front terminal voltage and the back terminal voltage of at least one of the plurality of utility power switches is greater than or equal to a preset threshold, determine that the at least one of the plurality of utility power switches is short-circuited and maintain the corresponding battery switch to be turned off; otherwise, determine that the plurality of utility power switches are normal, and control the corresponding battery switch to be turned on after a predetermined time.

In another aspect of the present disclosure, an electronic device is provided, which includes: a processor, and a memory connected in communication with the processor; the memory stores computer-executable instructions; and the processor executes computer-executable instructions stored in the memory to implement the method described above.

In another aspect of the present disclosure, a computer-readable storage medium is provided according to the present disclosure, where the computer-readable storage medium stores computer-executable instructions, and the computer-executable instructions, when executed by a processor, implement the method described above.

In the fault detection method, system, electronic device and medium provided according to the present disclosure, the first control signal is sequentially transmitted to the control chip corresponding to each of the plurality of battery switches, so that each of the plurality of battery switches to be turned off sequentially, when the battery switch is turned off, the difference between the front terminal voltage and the back terminal voltage of each of the plurality of utility power switches is detected. It is determined that the utility power switch is short-circuited in a case that the difference between the front terminal voltage and the back terminal voltage of the utility power is less than the predetermined threshold, and it is determined that the utility power switch is normal in a case that the difference between the front terminal voltage and the back terminal voltage of the utility power is greater than or equal to the predetermined threshold. The battery switch is maintained to be turned off to eliminate the reverse feeding fault, in a case that a short-circuited utility power switch is detected; and the battery switch is controlled to be turned on and the utility power switch connected to the next battery is detected continuously, in a case that no utility power switch is detected short-circuited. According to the fault detection method of the present disclosure, when a reverse feeding fault occurs in the multi-parallel system, the first control signal is transmitted among the modules, and the fault detection is achieved by sequentially detecting the difference between the front terminal voltage and the back terminal voltage of each of the plurality of utility power switches, so that the circuit design complexity is relatively low while the circuit fault is effectively detected, thereby effectively reducing the maintenance and production costs.

### BRIEF DESCRIPTION OF THE DRAWINGS

The drawings herein are incorporated into and constitute a part of the specification, illustrating embodiments complied with the present disclosure, and explaining the principles of the present disclosure with the specification.
FIG. 1 exemplarily shows a schematic structural diagram of an uninterruptible power supply in the related art;
FIG. 2 exemplarily shows a schematic structural diagram of another uninterruptible power supply according to an embodiment of the present disclosure;
FIG. 3 exemplarily shows a schematic flowchart of a fault detection method according to an embodiment of the present disclosure;
FIG. 4 exemplarily shows a schematic diagram of a first control signal according to an embodiment of the present disclosure;
FIG. 5 exemplarily shows a sequence diagram for fault detection according to an embodiment of the present disclosure;
FIG. 6 exemplarily shows a sequence diagram for fault detection according to an embodiment of the present disclosure; and
FIG. 7 exemplarily shows a schematic structural diagram of an electronic device according to an embodiment of the present disclosure.

Embodiments of the present disclosure are shown through the above drawings, which will be described in more detail hereinafter. These drawings and textual description are not intended to limit the scope of the concept of the present disclosure in any way, but rather to illustrate the concept of the present disclosure to those skilled in the art by reference to specific embodiments.

### DETAILED DESCRIPTION

Exemplary embodiments are described in detail herein, and examples of the embodiments are shown in the drawings. When the following description involves drawings, unless otherwise indicated, the same reference numerals in different drawings represent the same or similar elements. The implementations described in the following exemplary embodiments do not represent all the implementations consistent with the present disclosure. On the contrary, the following embodiments only show examples of apparatus and method consistent with some aspects of the present disclosure as detailed in the attached claims.

Modules in the present disclosure refer to functional modules or logical modules. The modules may be in the form of software, and the functions of the modules are implemented by the processor executing program codes. The modules may also be in the form of hardware. The term "and/or" describes a relationship between associated objects, and indicates that there may be three relationships. For example, "A and/or B" may indicate a case that there is only A, a case that there are both A and B, and a case that there is only B. The character "/" generally indicates an "or" relationship between the objects before and after.

A UPS is an uninterruptible power supply (Uninterruptible Power Supply), which is an uninterruptible power supply including an energy storage apparatus. The UPS is mainly used for some devices with a relatively high requirement for the stability of the power supply, and can supply power in two modes of utility power supply and battery, so as to provide an uninterrupted power supply. However, a risk of reverse feeding fault may occur in the uninterruptible power supply, that is, when the utility power switch is short-circuited in the battery mode, battery voltage reverse feeding may exist at a utility power input side of the uninterruptible power supply, which will bring an electric shock risk to maintenance personnel; and when the utility power suddenly recovers, a situation of mutual reverse feeding between the utility power supply and the battery voltage may occur, thereby further damaging the rectifier and causing the load to be powered down.

In the related art, the detection of reverse feeding fault may be realized by adding a high-precision current sensor at the utility power switch, however, this increases the complexity of circuit design and increases maintenance and production costs.

Hereinafter, the technical solutions of the present disclosure are exemplarily described in conjunction with specific embodiments. The following specific embodiments may be combined with each other, and similar concepts or processes may not be repeated in some embodiments.

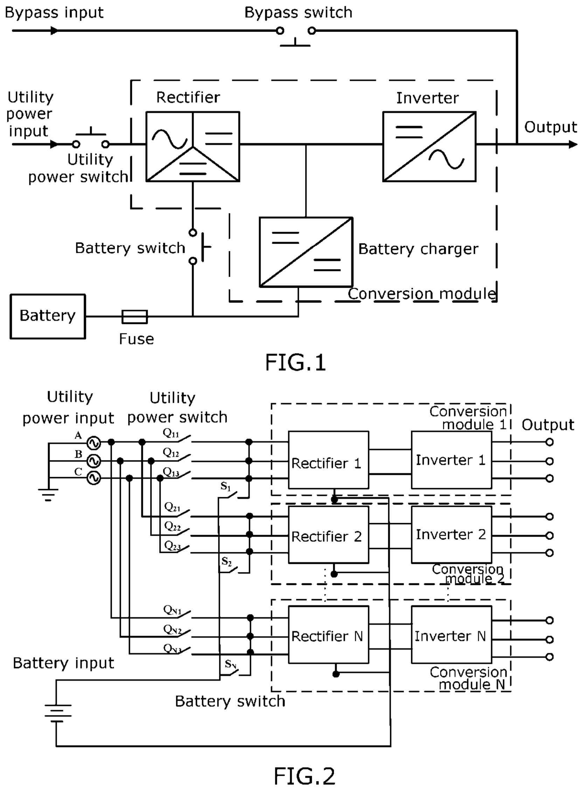

FIG. 1 is a schematic structural diagram of an uninterruptible power supply in the related art. As shown in FIG. 1, the uninterruptible power supply includes: a utility power switch, a battery switch, a battery and a conversion module. A utility power switch is connected between the utility power and the conversion module, a battery switch is connected between the battery and an output terminal of the utility power switch, and the conversion module is configured to supply power to a load.

The conversion module may include a rectifier, an inverter, and a battery charger, where a first input terminal of the rectifier receives utility power through a utility power switch, a second input terminal of the rectifier is connected to an output terminal of the battery through the battery switch, a first output terminal of the rectifier is connected to an input terminal of the inverter, a first output terminal of the rectifier is connected to the battery charger, and the inverter outputs alternating current(AC) to the load.

Specifically, the uninterruptible power supply may adopt a dual conversion mode. In a normal mode, the utility power switch is turned on, the battery switch is turned off, and the utility power supplies power to the rectifier. The rectifier converts the utility AC power to direct-current (DC) power, and the DC power is supplied to the inverter. The inverter converts the DC power to AC power, thereby supplying power to the load. Meanwhile the rectifier also provides DC charging current to the battery charger to charge the battery. In a case that the utility power is interrupted or abnormal, the uninterruptible power supply will automatically switch to a battery mode. In the battery mode, the utility power switch is turned off, and the battery switch is turned on. The battery outputs DC power to the rectifier, the rectifier supplies DC power to the inverter, the inverter converts the DC power to AC power, thereby supplying power to the load. In a case that the utility power is recovered, the uninterruptible power supply will switch back to the normal mode to ensure long-term stable and reliable operation of the load.

Exemplarily, a battery switch may be arranged between the battery and the rectifier, thereby effectively improving safety in the battery mode.

The dual conversion uninterruptible power supply realizes the isolation of the load from the utility power supply, and the output voltage and output frequency of the dual conversion uninterruptible power supply do not depend on the input voltage and frequency of the utility power, so as to protect the load from utility power interference such as surge/spike, line noise, undervoltage, overvoltage, lightning, frequency change, voltage distortion, voltage harmonics, or the like. In a case that the utility power fails, the uninterruptible power supply is able to instantaneously switch from the normal mode to the battery mode. During the switching process, the output power supply is uninterrupted, and the load can be continuously supplied safely without interruption, thereby effectively improving the reliability of the power supply.

In a possible embodiment, the uninterruptible power supply may further include a bypass mode. In a case that the uninterruptible power supply detects overload, load fault or internal fault, it will automatically switch to the bypass mode. In the bypass mode, both the utility power switch and the battery switch are turned off, and the bypass power supply (such as utility power) directly supplies power to the load through a bypass fuse, thereby further improving the reliability of the power supply.

In practical applications, a risk of reverse feeding fault may occur in the uninterruptible power supply. That is, when the utility power switch is short-circuited in the battery mode, a reverse feeding battery voltage may exist at a utility power input side of the uninterruptible power supply, which will bring an electric shock risk to maintenance personnel; and when the utility power suddenly recovers, a situation that the voltage across the utility power supply and the voltage across the battery are mutually filled may occur, thereby further damaging the rectifier and causing the load to be powered down.

In the related art, the detection of reverse feeding fault may be realized by adding a high-precision current sensor at the utility power switch. However, the complexity of circuit design will be increased, and maintenance and production costs will be increased.

Based on the above technical problems, a fault detection method for accurately detecting reverse feeding fault and reducing detection costs is provided according to the embodiments of the present disclosure.

FIG. 2 is a schematic structural diagram of another uninterruptible power supply according to an embodiment of the present disclosure. As shown in FIG. 2, the uninterruptible power supply may include a plurality of utility power switches, a plurality of battery switches, a battery and a plurality of conversion modules; each utility power switch is connected between a utility power and one of the plurality of conversion modules, each battery switch is connected between the battery and an output terminal of one of the plurality of utility power switches, and each conversion module is configured to supply power to a load.

Exemplarily, the utility power may be a three-phase AC power, and correspondingly, each rectifier is connected to three phases of the utility power through three utility power switches respectively.

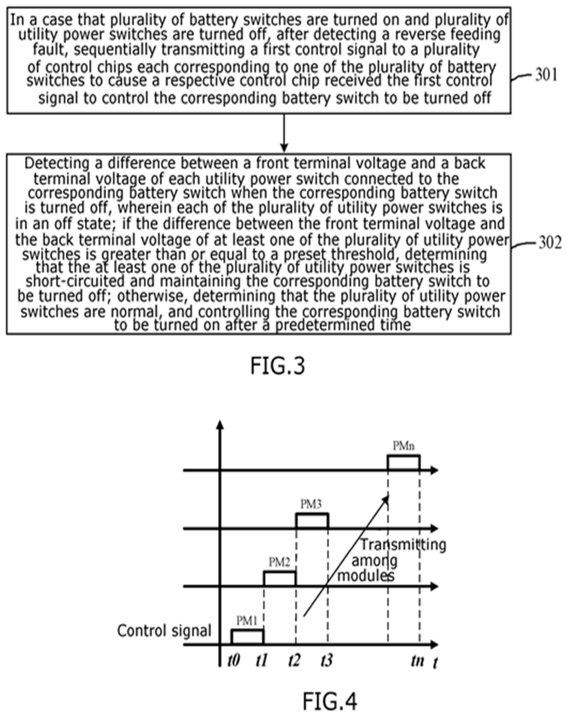

FIG. 3 is a schematic flowchart of a fault detection method according to an embodiment of the present disclosure. The method is applied to the uninterruptible power supply as shown in FIG. 1 and FIG. 2. The method includes steps S301 and S302.

In step S301, in a case that the plurality of battery switches are turned on and the plurality of utility power switches are turned off, after detecting a reverse feeding fault, sequentially transmitting a first control signal to a plurality of control chips each corresponding to one of the plurality of battery switches to cause a respective control chip received the first control signal to control the corresponding battery switch to be turned off.

In step S302, a difference between a front terminal voltage and a back terminal voltage of each utility power switch connected to the corresponding battery switch may be detected when the corresponding battery switch is turned off, wherein each of the plurality of utility power switches is in an off state; if the difference between the front terminal voltage and the back terminal voltage of at least one of the plurality of utility power switches may be greater than or equal to a preset threshold, it is determined that the at least one of the plurality of utility power switches is short-circuited and maintaining the corresponding battery switch to be turned off; otherwise, determining that the plurality of utility power switches are normal, and the corresponding battery switch may be controlled to be turned on after a predetermined time.

In a specific implementation, in the battery mode, the first control signal is sequentially transmitted to control chips corresponding to each of the plurality of battery switches after detecting the reverse feeding fault, in a case that the plurality of battery switches are turned on and the plurality of utility power switches are turned off, thereby causing the control chip receiving the first control signal to control the corresponding battery switch to be turned off. In this case, the load current is temporarily provided by the DC bus at the output terminal of the rectifier.

It is understood that the uninterruptible power supply may be disposed with a plurality of conversion modules and a plurality of battery switches, and each battery switch is connected to a conversion module and is configured to control whether the battery supplies power to the conversion module. A corresponding control chip is provided for each group of the battery switches and the conversion module. The control chip is capable of controlling the corresponding battery switch to be turned on or turned off, and is also capable of controlling the power device in the conversion module.

Exemplarily, the first control signal may be transmitted based on the timing corresponding to the conversion module ID (conversion module 1, conversion module 2... conversion module N).

Exemplarily, the first control signal may be a PowerWalk-In signal passed among modules. In a case that the uninterruptible power supply is switched back to the generator from the battery, the PowerWalk-In signal is sequentially transmitted among the battery switches, so that each conversion module is gradually switched back to the generator input terminal based on a power walk-in sequential logic, thus avoiding a plurality of conversion modules connected in parallel to bear overload, resulting in a tripping problem of the generator circuit breaker due to the decrease of rotational speed and the increase of input current when switching back from the battery, and meanwhile, reducing the cost of equipping large-capacity emergency generators for customers.

In one possible implementation, the method further includes: detecting whether a voltage at an input terminal of the utility power is greater than a reverse feeding threshold, and determining that the reverse feeding fault occurs when the voltage at the input terminal of the utility power is greater than the reverse feeding threshold.

FIG. 4 is a schematic diagram of a first control signal according to an embodiment of the present disclosure. As shown in FIG. 4, the PM1 segment of the first control signal is transmitted to the control chip corresponding to the battery switch S1, the PM2 segment of the first control signal is transmitted to the control chip corresponding to the battery switch S2, and so on.

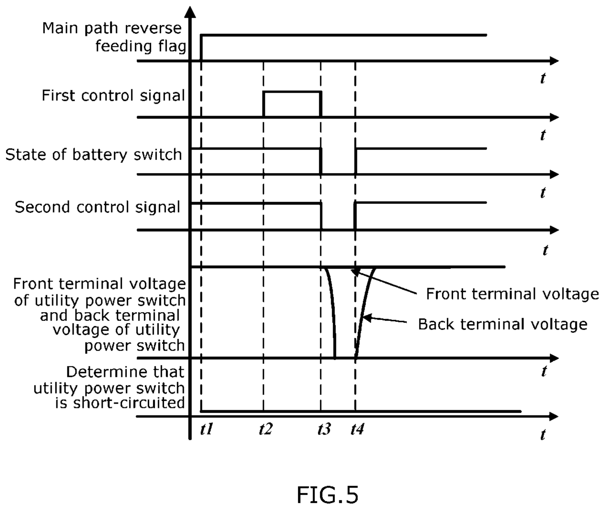

FIG. 5 is a sequence diagram for fault detection according to an embodiment of the present disclosure. As shown in FIG. 5, in a case that the utility power switch connected to the turned-off battery switch is not short-circuited, the control chip corresponding to the battery switch receives the first control signal at time t2, and the battery switch is turned off at time t3. As a result, the back terminal of the utility power switch no longer receives power supply from the battery, so that the voltage decreases rapidly and drops to zero. However, the reverse feeding voltage still occurs in the front terminal of the utility power switch, so that the difference between the front terminal voltage and the back terminal voltage is relatively large.

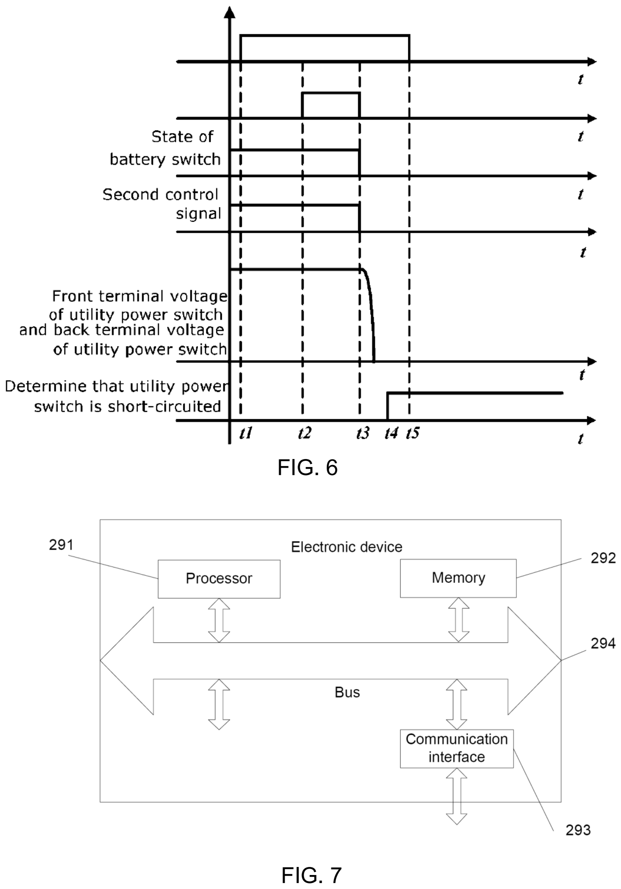

FIG. 6 is another sequence diagram for fault detection according to an embodiment of the present disclosure. As shown in FIG. 6, when the utility power switch connected to the turned-off battery switch is short-circuited, the control chip corresponding to the battery switch receives the first control signal at time t2. After the battery switch is turned off at time t3, the back terminals of the utility power switches no longer receive power supply from the battery, so that the voltage decreases rapidly and drops to zero, the front terminal and the back terminal of the utility power switch being short-circuited are connected, the voltage across the front terminal at time t3 decreases rapidly and drops to zero, the reverse feeding voltage disappears, and the difference between the front terminal voltage and the back terminal voltage is nearly zero.

It is understood that when a reverse feeding fault occurs, the reverse feeding voltage exists only at the phase of the utility power switch that the input terminal of the utility power corresponds to the fault. For example, when a short circuit occurs in utility power switch Q12, the reverse feeding voltage occurs in phase B of the input terminal of the utility power.

Therefore, after the battery switch is turned off, the difference between the front terminal voltage and the back terminal voltage of each of the utility power switches connected to the battery switch is detected. In a case that the voltage difference is less than the preset threshold, it is determined that the utility power switch is short-circuited, and in a case that the voltage difference is greater than or equal to the preset threshold, it is determined that the utility power switch is normal. In a case that all utility power switches connected to the turned-off battery switch are normal, the battery switch is controlled to be turned on after a predetermined time, and the first control signal is continuously transmitted to the control chip corresponding to the next battery switch until the utility power switch having fault is determined. As shown in FIG. 5, in a case that each utility power switch connected to the turned-off battery switch are normal, the battery switch is controlled by the control chip to be turned on at time t4, the battery is recovered and operates for discharging, and the back terminal voltage of each utility power switch connected to the battery switch is gradually restored. In a case that the utility power switch connected to the turned-off battery switch is faulty, the battery switch is maintained turned off. As shown in FIG. 6, in a case that a fault exists in each of the utility power switches connected to the turned-off battery switch, the battery switch remains to be turned off.

In the embodiments of the present disclosure, the first control signal is sequentially transmitted to control chips corresponding to each of the plurality of battery switches to cause each of the plurality of battery switches to be turned off. And in a case that the battery switch is turned off, the difference between the front terminal voltage and the back terminal of each of the plurality of utility power switches is detected. It is determined that utility power switch is short-circuited in a case that the difference between the front terminal voltage and the back terminal voltage of the utility power is less than the predetermined threshold, and it is determined that the utility power switch is normal in a case that the difference between the front terminal voltage and the back terminal voltage of the utility power is greater than or equal to the predetermined threshold. The battery switch is maintained to be turned off to eliminate the reverse feeding fault, in a case that a short-circuited utility power switch is detected; and the battery switch is controlled to be turned on and the utility power switch connected to the next battery is detected continuously, in a case that no utility power switch is detected short-circuited. In the fault detection method, in a case that the reverse feeding fault occurs in a multi-parallel system, the first control signal is transmitted among modules, and the fault detection is performed sequentially through the difference between the front terminal voltage and the back terminal voltage of the utility power switch. Polling operation in a full load range is supported, fault switches can be identified rapidly and reverse feeding fault can be eliminated, thereby reducing the risk of electric shock of maintenance personnel. Furthermore, the method is realized through software logic, so that production cost is reduced and high reliability of system power supply is realized.

In one possible implementation, as shown in FIG. 2, the conversion module includes a rectifier; an input terminal of the rectifier is connected to an output terminal of the utility power switch, an output terminal of the rectifier is connected to an input terminal of the battery, and the rectifier includes a power device. The fault detection method further includes: stopping sending a second control signal to a first power device, in a case that the battery switch is turned off, where the first power device is a power device included in a first rectifier, and the first rectifier is connected to the turned-off battery switch.

Specifically, in a case that the utility power switches and the battery switch are turned off, the first rectifier connected to the turned-off battery switch has no normal power supply input and cannot work normally. Therefore, in a case that the battery switch is released, the transmission of the second control signal to the first power device included in the first rectifier may be stopped.

As shown in FIG. 2, taking the battery switch S1 as an example. In a case that each utility power switch and the battery switch S1 are turned off, if all the utility power switches Q11, Q12, and Q13 connected to the battery switch S1 are normal, no current input exists in the rectifier 1 connected to the battery switch S1. As shown in FIG. 5, when the first control signal is released at time t2, the battery switch is turned off, and the transmission of the second control signal may be stopped at time t2. The battery switch is turned on at time t4, and thus the transmission of the second control signal is resumed at time t4.

Exemplarily, the second control signal may be a pulse width modulated (PWM) signal or the like, which is not limited herein.

In one possible implementation, as shown in FIG. 2, each conversion module further comprises an inverter, an input terminal of the inverter is connected to the output terminal of the rectifier, and an output terminal of the inverter is connected to the load.

In a specific implementation, the inverter is configured to convert DC power supplied by the rectifier into AC power, thereby providing AC power to the load.

In one possible implementation, as shown in FIG. 2, the number of the plurality of conversion modules is more than one, and the plurality of conversion modules are connected in parallel.

In a specific implementation, a plurality of conversion modules may be disposed, and each conversion module includes a rectifier and an inverter, where each rectifier is connected to a battery through a rectifier switch, each rectifier is connected to an inverter, and each rectifier is connected to a plurality of phases of the utility power through a plurality of utility power switches. For example, in a case that the utility power is three-phase power, each rectifier is connected to three utility power switches, the other terminals of the three utility power switches are connected to the three phases of the utility power. The plurality of rectifiers and the plurality of inverters may operate simultaneously, thereby achieving high-power power supply and improving power supply efficiency.

During fault detection, the battery switches are turned off one by one, and the conversion modules lose power supply one by one instead of simultaneously, thereby effectively reducing the risk of load power failure and improving the reliability of power supply.

In a possible implementation, before sequentially transmitting a first control signal to each of the plurality of battery switches, the method further includes: setting a main path reverse feeding flag for each of the plurality of conversion modules; wherein the method further includes: after determining that the reverse feeding fault is eliminated, clearing the main path reverse feeding flag.

As shown in FIG. 5, when a reverse feeding fault occurs at time t1, each conversion module is capable of detecting the reverse feeding fault and the main path reverse feeding flag is set to mark the occurrence of the reverse feeding fault. If it is determined that the utility power switch is not short-circuited, the main path reverse feeding flag is remained unchanged. As shown in FIG. 6, after the short-circuited utility power switch is determined at time t4, the corresponding battery switch remains to be turned off, and the reverse feeding voltage disappears. After each conversion module determines that the reverse feeding voltage disappears at time t6, the main path reverse feeding flag is cleared. The existence of reverse feeding fault in the power supply is indicated by the reverse feeding flag, so as to determine whether the fault detection and processing can be completed currently, thereby performing fault detection and power supply in an orderly manner.

According to the embodiment of the present disclosure, a power supply system is further provided, and includes the uninterruptible power supply and the detecting apparatus as shown in Figs. 1 and 2, wherein the uninterruptible power supply includes: a plurality of utility power switches, a plurality of battery switches, a battery and a plurality of conversion modules; each utility power switch is connected between a utility power and one of the plurality of conversion modules, each battery switch is connected between the battery and an output terminal of one of the plurality of utility power switches, and each conversion module is configured to supply power to a load; wherein the detecting apparatus comprises: a transmitting module configured to, after detecting a reverse feeding fault, sequentially transmit a first control signal to a plurality of control chips each corresponding to one of the plurality of battery switches to cause a respective control chip received the first control signal to control the corresponding battery switch to be turned off; and a detecting module configured to, detect a difference between a front terminal voltage and a back terminal voltage of each utility power switch connected to the corresponding battery switch when the corresponding battery switch is turned off, wherein each of the plurality of utility power switches is in an off state; if the difference between the front terminal voltage and the back terminal voltage of at least one of the plurality of utility power switches is greater than or equal to a preset threshold, determine that the at least one of the plurality of utility power switches is short-circuited and maintain the corresponding battery switch to be turned off; otherwise, determine that the plurality of utility power switches are normal, and control the corresponding battery switch to be turned on after a predetermined time.

In one possible implementation, the conversion module includes a rectifier, an input terminal of the rectifier is connected to an output terminal of the utility power switch, an output terminal of the rectifier is connected to an input terminal of the battery, the rectifier includes a power device, and the detecting apparatus further includes: a control module configured to stop sending a second control signal to a first power device, in a case that the battery switch is turned off, where the first power device is a power device included in a first rectifier, and the first rectifier is connected to the turned-off battery switch.

In one possible implementation, the conversion module further includes an inverter; an input terminal of the inverter is connected to an output terminal of the rectifier, and the output terminal of the inverter is connected to the load.

In one possible implementation, the number of the conversion module is more than one, and the plurality of conversion modules are connected in parallel.

In one possible implementation, the detecting apparatus further includes: a marking module configured to set a main path reverse feeding flag for each of the plurality of conversion modules after detecting a reverse feeding fault; and clear the main path reverse feeding flag, after determining that the reverse feeding fault is eliminated.

It should be illustrated that the detecting apparatus is configured to perform the fault detection method described above, and a specific implementation method thereof is described above, and will not be described herein.

FIG. 7 is a schematic structural diagram of an electronic device according to an embodiment of the present disclosure. As shown in FIG. 7, the electronic device includes: a processor 291, where the electronic device further includes a memory 292. Furthermore, a communication Interface 293 and a bus 294 may be included, wherein the processor 291, the memory 292, and the communication interface 293 may implement communication with each other via the bus 294. The communication interface 293 may be adopted for information transmission. The processor 291 may invoke logical instructions in the memory 292 to perform the method according to the embodiments described above.

In addition, the logical instructions in the memory 292 may be stored in a computer-readable storage medium when implemented in a form of a software functional unit and sold or used as an independent product.

As a computer-readable storage medium, the memory 292 may be used to store a software program, or a computer-executable program, such as program instructions/modules corresponding to the method according to the embodiment of the present disclosure. The processor 291 implements functional applications and data processing by executing the software program, instructions and modules stored in the memory 292, that is, realizes the method according to the embodiments described above.

The memory 292 may include a program storage area and a data storage area, where the program storage area may store an operating system and an application program required by at least one function; the data storage area may store data created according to the use of the terminal, or the like. In addition, the memory 292 may include a high-speed random access memory, and may also include a non-volatile memory.

**In** one aspect, a non-transitory computer-readable storage medium storing a computer program therein is provided according to an embodiment of the present disclosure. The computer program, when executed by a processor, implements the method according to the embodiments described above.

A computer program product including a computer program is also provided according to an embodiment of the present disclosure. The computer program, when executed by a processor, implements the method according to any of the embodiments described above.

Those skilled in the art may easily obtain other embodiments of the present disclosure after considering the specification and practicing the solutions disclosed herein. The present disclosure aims to including all variations, usages, or adaptive modifications of the present disclosure. These variations, usages, or adaptive modifications follow the general principles of the present disclosure and include common knowledge or customary technical means in the technical field not disclosed in the present disclosure. The specification and embodiments are only exemplary, and the scope and spirit of the present disclosure are determined by the following claims.

It should be understood that the present disclosure is not limited to the precise structure described above and shown in the drawings, and various modifications and variations may be made without departing from the scope of the present disclosure. The scope of the present disclosure is limited only by the claims.
Described herein are also the following clauses:
1. A fault detection method for an uninterruptible power supply, wherein the uninterruptible power supply comprises: a plurality of utility power switches, a plurality of battery switches, a battery and a plurality of conversion modules; each utility power switch is connected between a utility power and one of the plurality of conversion modules, each battery switch is connected between the battery and an output terminal of one of the plurality of utility power switches, and each conversion module is configured to supply power to a load, wherein the method comprises: in a case that the plurality of battery switches are turned on and the plurality of utility power switches are turned off, after detecting a reverse feeding fault, sequentially transmitting a first control signal to a plurality of control chips each corresponding to one of the plurality of battery switches to cause a respective control chip received the first control signal to control the corresponding battery switch to be turned off; and detecting a difference between a front terminal voltage and a back terminal voltage of each utility power switch connected to the corresponding battery switch when the corresponding battery switch is turned off, wherein each of the plurality of utility power switches is in an off state; if the difference between the front terminal voltage and the back terminal voltage of at least one of the plurality of utility power switches is greater than or equal to a preset threshold, determining that the at least one of the plurality of utility power switches is short-circuited and maintaining the corresponding battery switch to be turned off; otherwise, determining that the plurality of utility power switches are normal, and controlling the corresponding battery switch to be turned on after a predetermined time.
2. The method according to clause 1, wherein each of the plurality of conversion modules comprises one rectifier of a plurality of rectifiers, an input terminal of each rectifier is connected to an output terminal of each utility power switch, an output terminal of each rectifier is connected to an input terminal of the battery, each rectifier comprises a power device, and the method further comprises: stopping sending a second control signal to a first power device when a battery switch is turned off, wherein the first power device is a power device included in a first rectifier, and the first rectifier is connected to the turned-off battery switch.
3. The method according to clause 2, wherein each conversion module further comprises an inverter, an input terminal of the inverter is connected to the output terminal of the rectifier, and an output terminal of the inverter is connected to the load; the number of the plurality of conversion modules is more than one, and the plurality of conversion modules are connected in parallel.
4. The method according to clause 3, wherein before sequentially transmitting the first control signal to each of the plurality of battery switches, the method further comprises: setting a main path reverse feeding flag for each of the plurality of conversion modules; wherein
   the method further comprises: after determining that the reverse feeding fault is eliminated, clearing the main path reverse feeding flag.
5. The method according to any one of clauses 1 to 4, wherein the method further comprises:
   detecting whether a voltage at an input terminal of the utility power is greater than a reverse feeding threshold, and determining that the reverse feeding fault occurs when the voltage at the input terminal of the utility power is greater than the reverse feeding threshold.
6. A power supply system comprising an uninterruptible power supply and a detecting apparatus, wherein the uninterruptible power supply comprises: a plurality of utility power switches, a plurality of battery switches, a battery and a plurality of conversion modules; each utility power switch is connected between a utility power and one of the plurality of conversion modules, each battery switch is connected between the battery and an output terminal of one of the plurality of utility power switches, and each conversion module is configured to supply power to a load; wherein the detecting apparatus comprises: a transmitting module configured to, in a case that the plurality of battery switches are turned on and the plurality of utility power switches are turned off, after detecting a reverse feeding fault, sequentially transmit a first control signal to a plurality of control chips each corresponding to one of the plurality of battery switches to cause a respective control chip received the first control signal to control the corresponding battery switch to be turned off; and a detecting module configured to, detect a difference between a front terminal voltage and a back terminal voltage of each utility power switch connected to the corresponding battery switch when the corresponding battery switch is turned off, wherein each of the plurality of utility power switches is in an off state; if the difference between the front terminal voltage and the back terminal voltage of at least one of the plurality of utility power switches is greater than or equal to a preset threshold, determine that the at least one of the plurality of utility power switches is short-circuited and maintain the corresponding battery switch to be turned off; otherwise, determine that the plurality of utility power switches are normal, and control the corresponding battery switch to be turned on after a predetermined time.
7. The system according to clause 6, wherein each of the plurality of conversion modules comprises one rectifier of a plurality of rectifiers, an input terminal of each rectifier is connected to an output terminal of each utility power switch, an output terminal of each rectifier is connected to an input terminal of the battery, each rectifier comprises a power device, and the detecting module is further configured to:stop sending a second control signal to a first power device when a battery switch is turned off, wherein the first power device is a power device included in a first rectifier, and the first rectifier is connected to the turned-off battery switch.
8. The system according to clause 7, wherein each conversion module further comprises an inverter, an input terminal of the inverter is connected to the output terminal of the rectifier, and an output terminal of the inverter is connected to the load; the number of the plurality of conversion modules is more than one, and the plurality of conversion modules are connected in parallel.
9. An electronic device comprising: a processor and a memory connected in communication with the processor, wherein the memory is configured to store computer-executable instructions; and the processor is configured to execute the computer-executable instructions stored in the memory to implement the method according to any one of claims 1 to 5.
10. A computer-readable storage medium, wherein the computer-readable storage medium is configured to store computer-executable instructions, and the computer-executable instructions, when executed by a processor, implement the method according to any one of clauses 1 to 5.

## Claims

1. A fault detection method for an uninterruptible power supply, wherein the uninterruptible power supply comprises: a plurality of utility power switches, a plurality of battery switches, a battery and a plurality of conversion modules; each utility power switch is connected between a utility power and one of the plurality of conversion modules, each battery switch is connected between the battery and an output terminal of one of the plurality of utility power switches, and each conversion module is configured to supply power to a load, wherein the method comprises:
in a case that the plurality of battery switches are turned on and the plurality of utility power switches are turned off, after detecting a reverse feeding fault, sequentially transmitting a first control signal to a plurality of control chips each corresponding to one of the plurality of battery switches to cause a respective control chip received the first control signal to control the corresponding battery switch to be turned off; and
detecting a difference between a front terminal voltage and a back terminal voltage of each utility power switch connected to the corresponding battery switch when the corresponding battery switch is turned off, wherein each of the plurality of utility power switches is in an off state; if the difference between the front terminal voltage and the back terminal voltage of at least one of the plurality of utility power switches is greater than or equal to a preset threshold, determining that the at least one of the plurality of utility power switches is short-circuited and maintaining the corresponding battery switch to be turned off; otherwise, determining that the plurality of utility power switches are normal, and controlling the corresponding battery switch to be turned on after a predetermined time.

2. The method according to claim 1, wherein each of the plurality of conversion modules comprises one rectifier of a plurality of rectifiers, an input terminal of each rectifier is connected to an output terminal of each utility power switch, an output terminal of each rectifier is connected to an input terminal of the battery, each rectifier comprises a power device, and the method further comprises:
stopping sending a second control signal to a first power device when a battery switch is turned off, wherein the first power device is a power device included in a first rectifier, and the first rectifier is connected to the turned-off battery switch.

3. The method according to claim 2, wherein each conversion module further comprises an inverter, an input terminal of the inverter is connected to the output terminal of the rectifier, and an output terminal of the inverter is connected to the load; the number of the plurality of conversion modules is more than one, and the plurality of conversion modules are connected in parallel.

4. The method according to claim 3, wherein before sequentially transmitting the first control signal to each of the plurality of battery switches, the method further comprises:
setting a main path reverse feeding flag for each of the plurality of conversion modules;
wherein
the method further comprises:
after determining that the reverse feeding fault is eliminated, clearing the main path reverse feeding flag .

5. The method according to any one of claims 1 to 4, wherein the method further comprises:
detecting whether a voltage at an input terminal of the utility power is greater than a reverse feeding threshold, and determining that the reverse feeding fault occurs when the voltage at the input terminal of the utility power is greater than the reverse feeding threshold.

6. A power supply system comprising an uninterruptible power supply and a detecting apparatus, wherein
the uninterruptible power supply comprises: a plurality of utility power switches, a plurality of battery switches, a battery and a plurality of conversion modules; each utility power switch is connected between a utility power and one of the plurality of conversion modules, each battery switch is connected between the battery and an output terminal of one of the plurality of utility power switches, and each conversion module is configured to supply power to a load; wherein
the detecting apparatus comprises:
a transmitting module configured to, in a case that the plurality of battery switches are turned on and the plurality of utility power switches are turned off, after detecting a reverse feeding fault, sequentially transmit a first control signal to a plurality of control chips each corresponding to one of the plurality of battery switches to cause a respective control chip received the first control signal to control the corresponding battery switch to be turned off; and
a detecting module configured to, detect a difference between a front terminal voltage and a back terminal voltage of each utility power switch connected to the corresponding battery switch when the corresponding battery switch is turned off, wherein each of the plurality of utility power switches is in an off state; if the difference between the front terminal voltage and the back terminal voltage of at least one of the plurality of utility power switches is greater than or equal to a preset threshold, determine that the at least one of the plurality of utility power switches is short-circuited and maintain the corresponding battery switch to be turned off; otherwise, determine that the plurality of utility power switches are normal, and control the corresponding battery switch to be turned on after a predetermined time.

7. The system according to claim 6, wherein each of the plurality of conversion modules comprises one rectifier of a plurality of rectifiers, an input terminal of each rectifier is connected to an output terminal of each utility power switch, an output terminal of each rectifier is connected to an input terminal of the battery, each rectifier comprises a power device, and the detecting module is further configured to:
stop sending a second control signal to a first power device when a battery switch is turned off, wherein the first power device is a power device included in a first rectifier, and the first rectifier is connected to the turned-off battery switch.

8. The system according to claim 7, wherein each conversion module further comprises an inverter, an input terminal of the inverter is connected to the output terminal of the rectifier, and an output terminal of the inverter is connected to the load; the number of the plurality of conversion modules is more than one, and the plurality of conversion modules are connected in parallel.

9. An electronic device comprising: a processor and a memory connected in communication with the processor, wherein
the memory is configured to store computer-executable instructions; and
the processor is configured to execute the computer-executable instructions stored in the memory to implement the method according to any one of claims 1 to 5.

10. A computer-readable storage medium, wherein the computer-readable storage medium is configured to store computer-executable instructions, and the computer-executable instructions, when executed by a processor, implement the method according to any one of claims 1 to 5.
